# EUROPÄISCHE PATENTANMELDUNG

(11) **EP 1 186 902 A2**
(43) Veröffentlichungstag der Anmeldung: **13.03.2002**
(21) Anmeldenummer: 01116491.0
(22) Anmeldetag: 06.07.2001
(51) Int. Cl.: G01R 31/3183

(54) **Prüfmodul**

(30) Priorität: 11.08.2000 DE 10040050
(71) Anmelder: SIEMENS AKTIENGESELLSCHAFT, 80333 München (DE)
(72) Erfinder: Troedel, Bernhard, 65550 Limburg/Lahn (DE)

(57) **Zusammenfassung**

Es wird ein Prüfmodul (1) zum vergleichenden Testen einer Elektronikkomponente (2) und eines die Funktion der Elektronikkomponente (2) im wesentlichen in Form eines Programms nachbildenden Simulationsmoduls (3) vorgeschlagen. Das Prüfmodul (1) weist eine Eingangs-/Ausgangsschnittstelle zu einem externen, mit der zu prüfenden Elektronikkomponente (2) zusammenwirkenden Modul (4) sowie der Elektronikkomponente (2) und dem Simulationsmodul (3) selbst auf. Äquivalente Eingangschnittstellen der Elektronikkomponente (2) und des Simulationsmoduls (3) werden durch das Prüfmodul (1) miteinander verbunden. Weiterhin weist das Prüfmodul (1) einen Komparator (6) zum Vergleichen von Ausgangssignalen der Elektronikkomponente (2) und des Simulationsmoduls (3) sowie einen mit dem Komparator (6) verknüpften Protokollspeicher (7) auf. Das erfindungsgemäße Prüfmodul (1) erlaubt einen schnellen vergleichenden Test der Funktionen der Elektronikkomponente (2) und des Simulationsmoduls (3).

## Beschreibung

Die Erfindung betrifft ein Prüfmodul zum vergleichenden Testen einer mit mindestens einer Eingangs- und Ausgangsschnittstelle versehenen Elektronikkomponente und eines die Funktionen der Elektronikkomponente im wesentlichen in Form eines Programms nachbildenden Simulationsmoduls mit ebenfalls mindestens einer Eingangs- und Ausgangsschnittstelle. Weiterhin betrifft die Erfindung ein Verfahren zum vergleichenden Testen einer solchen Elektronikkomponente und eines solchen Simulationsmoduls.

Der Entwurf von Elektronikkomponenten erfolgt in vielen Fällen computerunterstützt. Hierbei wird die komplette Schaltung am Computer entworfen und getestet. Das dabei entworfene Simulationsmodul bildet die Funktionen der realen Elektronikkomponente im wesentlichen in Form eines Programms nach. Über Eingangs- und Ausgangsschnittstellen kann das Simulationsmodul zudem mit einem oder mehreren externen Modulen zusammenwirken, welche auch zum Zusammenspiel mit der realen Elektronikkomponente vorgesehen sind. Zwischen dem Simulationsmodul und einem externen Modul werden dabei entsprechende, insbesondere digitale, Signale ausgetauscht. Erst nach einem zufriedenstellenden Verhalten der elektronisch entworfenen Schaltung wird die reale Elektronikkomponente in Form einer elektronischen Schaltung hergestellt und deren Zusammenspiel mit dem externen Modul getestet. Hierbei können Abweichungen im Zusammenspiel zwischen dem externen Modul und der realen Elektronikkomponente bzw. dem Simulationsmodul auftreten. Diese Abweichungen können beispielsweise durch Abweichungen der realen Bauelemente der Elektronikkomponente von den vereinfachenden Computermodellen im Simulationsmodul verursacht sein. Zum anderen können die Abweichungen jedoch auch auf Fehler in der Elektronikkomponente zurückzuführen sein. Aus diesen Gründen werden das Zeitverhalten und die Signalinhalte des Zusammenspiel des externen Moduls mit der Elektronikkomponente bzw. dem Simulationsmodul überprüft. Hierzu werden sowohl für die Verbindung des externen Moduls mit der Elektronikkomponente als auch für die Verbindung des externen Moduls mit dem Simulationsmodul Protokolle erstellt und manuell kontrolliert. Diese Vorgehensweise ist jedoch aufwendig und kann zudem dazu führen, das Abweichungen unentdeckt bleiben.

Aufgabe der Erfindung ist es daher, ein Prüfmodul anzugeben, mit dem ein vereinfachtes vergleichendes Testen der Elektronikkomponente und des Simulationsmoduls erreicht werden kann. Eine weitere Aufgabe der Erfindung ist die Angabe eines automatisierten Verfahrens zum vergleichenden Testen der Elektronikkomponente und des zugehörigen Simulationsmodells.

Die erstgenannte Aufgabe wird gelöst durch ein Prüfmodul zum vergleichenden Testen einer mit mindestens einer Eingangs- und Ausgangsschnittstelle versehenen Elektronikkomponente und eines die Funktionen der Elektronikkomponente im wesentlichen in Form eines Programms nachbildenden Simulationsmoduls mit ebenfalls mindestens einer Eingangs- und Ausgangsschnittstelle, wobei das Prüfmodul eine Eingangs-/Ausgangsschnittstelle zu einem externen, mit der zu prüfenden Elektronikkomponente zusammenwirkenden Modul, sowie der Elektronikkomponente und dem Simulationsmodul aufweist, äquivalente Eingangsschnittstellen der Elektronikkomponente und des Simulationsmoduls durch das Prüfmodul miteinander verbunden werden und ferner das Prüfmodul einen Komparator zum Vergleichen von Ausgangssignalen der Elektronikkomponente und des Simulationsmoduls sowie einen mit dem Komparator verknüpften Protokollspeicher aufweist.

Durch das erfindungsgemäße Prüfmodul werden sowohl die Elektronikkomponente als auch das Simulationsmodul mit denselben, von dem externen Modul ausgesendeten Signalen beispielsweise über einen Bus versorgt. Sowohl in der Elektronikkomponente als auch im Simulationsmodul werden dann die entsprechenden Antwortsignale generiert, die einem Komparator zugeleitet und dort automatisch verglichen werden. Der Komparator ist mit einem Protokollspeicher verbunden, in dem die Ergebnisse dieses Vergleichs abgespeichert werden können. In einer bevorzugten Ausgestaltung der Erfindung werden nur solche Ereignisse abgespeichert, bei denen von dem Komparator ein Unterschied in den Ausgangssignalen der Elektronikkomponenten und des Simulationsmoduls detektiert wurde. In diesem Fall ist in dem Protokollspeicher ein besonders einfach auszuwertendes Fehlerprotokoll abgespeichert.

Die Elektronikkomponente ist insbesondere eine digitale elektronische Schaltung, die digitale Eingangssignale erhält und digitale Ausgangssignale generiert. Eine spezielle Anwendungsform der Erfindung ist das Prüfen von Elektronikkomponenten für Kraftfahrzeuge, beispielsweise solche, die Bestandteil von Audio- und Navigationssystemen sind und über einen in Kraftfahrzeuganwendungen üblichen Bus kommunizieren.

In einer besonderen Ausgestaltung enthält das Prüfmodul einen Wahlschalter, der eine Weiterleitung von Ausgangssignalen der Elektronikkomponente und/oder des Simulationsmoduls an das externe Modul gestattet. Hierdurch können unterschiedliche Szenarien realisiert werden. Beispielsweise kann durch den Wahlschalter das Ausgangssignal der Elektronikkomponente direkt mit dem externen Modul verbunden werden, während das Simulationsmodul zur Kontrolle mitläuft und die Differenzen in den Ausgangssignalen der Elektronikkomponente und des Simulationsmoduls im Protokollspeicher aufgezeichnet werden.

In einer zweiten Position des Wahlschalters werden die Ausgangssignale des Simulationsmoduls direkt mit dem externen Modul verbunden und die Elektronikkomponente läuft zur Kontrolle mit, wobei wiederum die Differenzen in den Ausgangssignalen des Simulationsmoduls und der Elektronikkomponente aufgezeichnet werden. Im Gegensatz zur ersten Variante werden hierbei die Reaktionen der externen Komponente durch das Ausgangssignal des Simulationsmoduls bedingt.

In einer dritten Stellung des Wahlschalters werden sowohl die Elektronikkomponente als auch das Simulationsmodul mit dem externen Modul verbunden, wobei jedoch sichergestellt ist, dass die Ausgangssignale des Simulationsmoduls nur dann an das externe Modul weitergeleitet werden, wenn die Antworttelegramme von Funktionen in der Elektronikkomponente nicht oder nicht richtig implementiert sind.

Bei einem erfindungsgemäßen Verfahren zum vergleichenden Testen einer mit mindestens einer Eingangs- und Ausgangsschnittstelle versehenen Elektronikkomponente und eines die Funktionen der Elektronikkomponente im wesentlichen in Form eines Programms nachbildenden Simulationsmoduls mit ebenfalls mindestens einer Eingangs- und Ausgangsschnittstelle werden äquivalente Eingangsschnittstellen der Elektronikkomponente und des Simulationsmoduls zum Empfang von Signalen eines externen, mit der zu prüfenden Elektronikkomponente zusammen wirkenden Moduls miteinander verbunden und Ausgangssignale der Elektronikkomponente und des Simulationsmoduls werden automatisch miteinander verglichen und bei Abweichungen in einem Protokollspeicher abgespeichert.

Weitere vorteilhafte Ausgestaltungen der Erfindung sind in den Unteransprüchen angegeben.

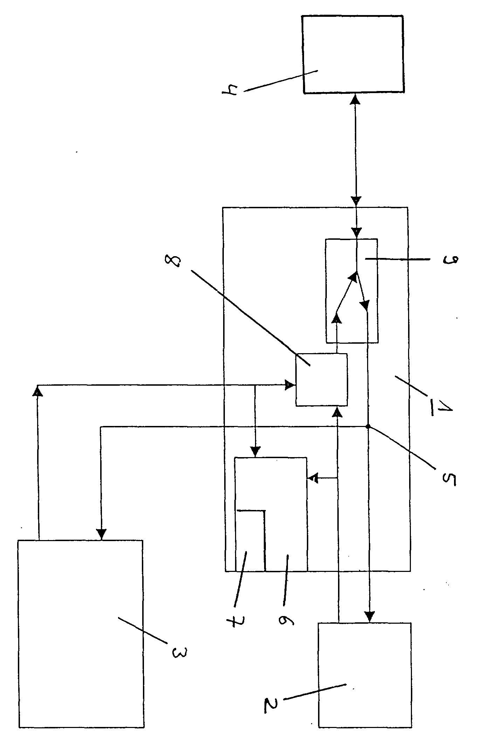

Nachfolgend wird die Erfindung anhand eines Ausführungsbeispiels und der Zeichnung näher erläutert. Die einzige Figur zeigt ein erfindungsgemäßes Prüfmodul mit daran angeschlossener Elektronikkomponente, Simulationsmodul und externem Modul.

Im Ausführungsbeispiel ist das Prüfmodul 1 über nicht näher dargestellte Schnittstellen sowohl mit der zu prüfenden Elektronikkomponente 2 und dem Simulationsmodul 3 als auch einem externen Modul 4 verbunden. Das Simulationsmodul ist in Form eines Programms ausgebildet, das auf einem Computer abläuft mit der erforderlichen Ein-/Ausgabeschnittstelle abläuft. Zwischen der Elektronikkomponente 2 bzw. dem Prüfmodul 3 und dem externen Modul 4 werden Signale ausgetauscht. Äquivalente Eingangsschnittstellen der Elektronikkomponente 2 und des Simulationsmoduls 3 werden mit den gleichen Eingangssignalen versorgt, was gemäß Ausführungsbeispiel durch den Knoten 5 realisiert wird. Die aufgrund der Eingangssignale von der Elektronikkomponente 2 und dem Simulationsmodul 3 generierten Ausgarigssignale werden einem Komparator 6 zugeleitet. Im Komparator 6 werden diese beiden Ausgangssignale miteinander verglichen und bei Abweichungen wird ein entsprechender Eintrag in einem Protokollspeicher 7 vorgenommen. Der Inhalt des Protokollspeichers 7 kann über eine nicht dargestellte Schnittstelle ausgelesen oder ausgedruckt werden. Das Prüfmodul 1 enthält ferner einen Wahlschalter 8, der sowohl mit der Ausgangsschnittstelle der Elektronikkomponente 2 als auch des Simulationsmoduls 3 verknüpft ist. Mittels des Wahlschalters 8 können die Ausgangssignale der Elektronikkomponente 2 und/oder des Simulationsmoduls 3 mit dem externen Modul 4 verbunden werden.

In einem ersten Betriebsmodus des Prüfmoduls 1 werden mittels des Wahlschalters 8 die Ausgangssignale der Elektronikkomponente 2 an das externe Modul weitergeleitet. In diesem Falle wird somit direkt das Zusammenspiel zwischen der Elektronikkomponente 2 und dem externen Modul 4 getestet, wobei als Vergleichswerte auch von dem Simulationsmodul 3 Ausgangssignale generiert werden, die dem Komparator 6 zugeleitet und dort mit den Ausgangssignalen des Elektronikmoduls 2 verglichen werden.

In einem zweiten Betriebsmodus des Prüfmoduls 1 werden mittels des Wahlschalters 8 die Ausgangssignale des Simulationsmoduls dem externen Modul 4 zugeleitet. In diesem Fall erfolgt somit ein Zusammenspiel des externen Moduls 4 mit dem Simulationsmodul 3, während die Elektronikkomponente 2 als Vergleichseinheit mitläuft. Die Ausgangssignale der Elektronikkomponente 2 werden im Komparator 6 zugeleitet und dort mit den Ausgangssignalen des Simulationsmoduls 3 verglichen. Dieser Betriebsmodus eignet sich insbesondere dann, wenn das Zusammenspiel zwischen dem Simulationsmodul 3 und dem externen Modul 4 zufriedenstellend erfolgt, während von der zu testenden Elektronikkomponente noch vermehrt Fehlersignale generiert werden. In diesen Betriebsmodus können in diesem Fall relativ schnell unterschiedliche Betriebszustände durchgespielt werden und die dabei auftretenden Fehler der Elektronikkomponente registriert werden.

In einem dritten Betriebsmodus des Prüfmoduls 1 werden dem externen Modul 4 sowohl Ausgangssignale von der Elektronikkomponente 2 als auch von dem Simulationsmodul 3 zugeleitet. In diesem Betriebsmodus können somit auch Funktionen getestet werden, die in der Elektronikkomponente 2 noch nicht implementiert sind, so dass von der Elektronikkomponente 2 kein entsprechendes Ausgangssignal generiert wird.

Im dargestellten Ausführungsbeispiel weist das Prüfmodul 1 als weitere Komponente einen Splitter 9 im Empfangs- und Sendezweig auf, über den eine Signalaufteilung vorgenommen wird.

Die Erfindung wurde anhand eines Ausführungsbeispiels erläutert. Spezielle Ausgestaltungen einzelnen Funktionsgruppen des Prüfmoduls wie beispielsweise des Komparators 6, des Wahlschalters 7 oder des Splitters 9 sind dem Fachmann bekannt und können in vielfältiger Weise realisiert werden.

## Patentansprüche

1. Prüfmodul (1) zum vergleichenden Testen einer mit mindestens einer Eingangs- und Ausgangsschnittstelle versehenen Elektronikkomponente (2) und eines die Funktionen der Elektronikkomponente (2) im wesentlichen in Form eines Programms nachbildenden Simulationsmoduls (3) mit ebenfalls mindestens einer Eingangs- und Ausgangsschnittstelle, wobei
- das Prüfmodul (1) eine Eingangs-/Ausgangsschnittstelle zu einem externen, mit der zu prüfenden Elektronikkomponente (2) zusammenwirkenden Modul (4), sowie der Elektronikkomponente (2) und dem Simulationsmodul (3) aufweist,
- äquivalente Eingangsschnittstellen der Elektronikkomponente (2) und des Simulationsmoduls (3) durch das Prüfmodul (1) miteinander verbunden werden und ferner
- das Prüfmodul (1) einen Komparator (6) zum Vergleichen von Ausgangssignalen der Elektronikkomponente (2) und des Simulationsmoduls (3), sowie
- einen mit dem Komparator (6) verknüpften Protokollspeicher (7) aufweist.

2. Prüfmodul nach Anspruch 1, **dadurch gekennzeichnet, dass** das Prüfmodul (1) einen Splitter (9) zum Aufteilen eines vom externen Modul (4) empfangenen Signals auf die Eingangsschnittstellen der Elektronikkomponente (2) und des Simulationsmoduls (3) aufweist.

3. Prüfmodul nach Anspruch 1 oder 2, **dadurch gekennzeichnet, dass** das Prüfmodul (1) einen Wahlschalter (8) enthält, der eine Weiterleitung von Ausgangssignalen der Elektronikkomponente (2) und / oder des Simulationsmoduls (3) an das externe Modul (4) gestattet.

4. Verfahren zum vergleichenden Testen einer mit mindestens einer Eingangs- und Ausgangsschnittstelle versehenen Elektronikkomponente (2) und eines die Funktionen der Elektronikkomponente (2) im wesentlichen in Form eines Programms nachbildenden Simulationsmoduls (3) mit ebenfalls mindestens einer Eingangs- und Ausgangsschnittstelle, wobei äquivalente Eingangsschnittstellen der Elektronikkomponente (2) und des Simulationsmoduls (3) zum Empfang von Signalen eines externen, mit der zu prüfenden Elektronikkomponente zusammenwirkenden Moduls (4) miteinander verbunden und Ausgangssignale der Elektronikkomponente (2) und des Simulationsmoduls (3) automatisch miteinander verglichen und bei Abweichungen in einem Protokollspeicher (7) abgespeichert werden.

5. Verfahren nach Anspruch 4, **dadurch gekennzeichnet, dass** Ausgangssignale der Elektronikkomponente (2) an das externe Modul (4) weitergeleitet werden.

6. Verfahren nach Anspruch 4, **dadurch gekennzeichnet, dass** Ausgangssignale des Simulationsmoduls (3) an das externe Modul (4) weitergeleitet werden.

7. Verfahren nach Anspruch 4, **dadurch gekennzeichnet, dass** sowohl Ausgangssignale der Elektronikkomponente (2) als auch Ausgangssignale des Simulationsmoduls (3) an das externe Modul (4) weitergeleitet werden.

8. Verfahren nach Anspruch 7, **dadurch gekennzeichnet, dass** Ausgangssignale des Simulationsmoduls (3) nur dann an das externe Modul (4) weitergeleitet werden, wenn ein entsprechendes Ausgangssignal der Elektronikkomponente (2) nicht zur Verfügung steht.
